# EUROPEAN PATENT SPECIFICATION

(11) **EP 4 319 495 B1**
(45) Date of publication and mention of the grant of the patent: **26.11.2025**
(21) Application number: 21943396.8
(22) Date of filing: 31.05.2021
(51) Int. Cl.: H05K 1/02, H05K 7/20

(54) **POWER ADAPTER AND ELECTRONIC DEVICE SYSTEM**
NETZTEIL UND ELEKTRONISCHES GERÄTESYSTEM
SYSTÈME D'ADAPTATEUR D'ALIMENTATION ET DE DISPOSITIF ÉLECTRONIQUE

(43) Date of publication of application: 07.02.2024
(73) Proprietor: Huawei Digital Power Technologies Co., Ltd., Shenzhen, Guangdong 518043 (CN)
(72) Inventor: XU, Chunxia, Shenzhen, Guangdong 518129 (CN); HUI, Xiaowei, Shenzhen, Guangdong 518129 (CN); WU, Hao, Shenzhen, Guangdong 518129 (CN)
(74) Representative: Isarpatent
(86) International application number: PCT/CN2021/097279
(87) International publication number: WO 2022/252019

(56) References cited:
- CN-A- 102 064 675
- CN-A- 105 744 732
- CN-A- 105 873 357
- CN-A- 106 877 629
- US-A1- 2007 127 217
- US-A1- 2009 154 113
- US-A1- 2014 160 638

## Description

### TECHNICAL FIELD

This application relates to the field of heat dissipation technologies, and in particular, to a power adapter and an electronic device system.

### BACKGROUND

With rapid development of electronic devices such as a smartphone and a laptop computer, as well as popularization of fast charging technologies, a charging power of a power adapter (power adapter) for charging an electronic device has gradually increased. As a result, when the power adapter is working, a heating power of an internal electronic component increases accordingly. In addition, to improve portability of the power adapter, a volume of the power adapter continuously evolves toward miniaturization, leading to a continuous rise in heating power density. Therefore, more efficient heat dissipation is required for the power adapter.

Currently, a heat dissipation manner of the power adapter is usually filling a thermally conductive adhesive in the power adapter, to transfer heat generated by the electronic component to a housing by using the thermally conductive adhesive, thereby accelerating heat dissipation. An increase in a thermal conductivity of the thermally conductive adhesive causes poor fluidity of the thermally conductive adhesive. When a thermally conductive adhesive with a low thermal conductivity is used, although internal encapsulation may be implemented and a heat dissipation area is increased, heat dissipation effect is poor due to the low thermal conductivity, and a local hot spot is easily formed in the power adapter and on the housing. When a thermally conductive adhesive with a high thermal conductivity is used, encapsulation cannot be implemented due to poor fluidity, and only the internal electronic component can be dispensed with the adhesive. This reduces a heat dissipation area, and a local hot spot is also easily formed in the power adapter and on the housing.

In conclusion, currently the heat dissipation effect of the power adapter is poor, which limits a further increase in the charging power of the power adapter.

CN 106 877 629 A discloses a power adapter with radiating pins.

US 2009/154113 A1 discloses a device which includes power source circuitry, a circuit board supporting electrical components to receive electrical power from the power source circuitry.

US 2007/127217 A1 discloses an electronic device which comprises an envelope comprising a closed chamber and a printed-circuit board.

### SUMMARY

This application provides a power adapter and an electronic device system, as defined in the appended set of claims, to improve heat dissipation effect of the power adapter, to further increase a charging power of the power adapter.

According to the technical solution provided in this application, the insulation powder is filled in the housing of the power adapter. The insulation powder is a solid. Compared with a thermally conductive adhesive, the insulation powder does not have a problem of poor fluidity, and can more easily be sufficiently filled. In other words, a contact area between the insulation powder and the printed circuit board assembly is ensured, and the heat can be efficiently transferred from the printed circuit board assembly to the insulation powder. This improves heat dissipation effect of the power adapter, and helps further increase the charging power of the power adapter.

In the solution provided in this application, a material with a larger specific heat capacity is selected as the heat storage powder, and a heat absorption capability is strong. When an instantaneous heating power of the printed circuit board assembly is high, the heat storage powder may absorb a large amount of heat generated by the printed circuit board assembly in a short time. After the instantaneous heating power of the printed circuit board assembly decreases, the heat storage powder gradually releases the stored heat and conducts the heat to the housing. This avoids overheating of the printed circuit board assembly in a short time. A material with a high thermal conductivity is selected as the thermally conductive powder. In this case, when a heating power of the printed circuit board assembly is continuously high, the heat generated by the printed circuit board assembly may be continuously and quickly conducted to the housing, thereby alleviating heat accumulation of the printed circuit board assembly.

A proportion of the thermally conductive powder filled in the housing is greater than a proportion of the filled heat storage powder, and the proportion is a mass ratio or a volume ratio.

In this case, the power adapter is configured to charge an electronic device with a high battery capacity, such as a laptop computer, and the charging power of the power adapter keeps high throughout a charging process. To continuously and quickly conduct the heat generated by the printed circuit board assembly to the housing and to alleviate heat accumulation of the printed circuit board assembly, the proportion of the filled thermally conductive powder is greater than the proportion of the filled heat storage powder, to improve a heat conduction capability

An additional layer of inner housing is disposed in the power adapter. This can avoid direct leakage of the insulation powder due to housing breakage. In addition, because the housing and the inner housing form the enclosed cavity, the heat is further dissipated in a process of conduction to the housing through the inner housing and the cavity. Therefore, a local hot spot due to direct heat dissipation through the housing is not formed, improving user experience.

In a possible implementation, a thermally conductive adhesive or a coolant is filled in the enclosed cavity. In this way, a dissipation effect when the heat is conducted to the housing through the inner housing and the cavity is improved, to avoid forming a local hot spot.

In a possible implementation, the inner housing is made of a metal material to improve heat transfer efficiency.

One side of the inner housing is in direct contact with the printed circuit board assembly, and the other side of the inner housing is in direct contact with the insulation powder. Therefore, the inner housing may quickly transfer the heat generated by the printed circuit board assembly to the insulation powder.

In a possible implementation, the inner housing is provided with a slot, and the slot is configured to accommodate an electronic component on the printed circuit board assembly.

This implementation increases a contact area between the inner housing and the electronic component, and increases a speed at which the inner housing transfers the heat generated by the printed circuit board assembly to the insulation powder. In addition, the slot further has a function of supporting the electronic component. This enhances stability of the electronic component, and therefore further improves reliability of the power adapter.

When the power adapter includes a plurality of output interfaces, the power adapter may charge a plurality of electronic devices of a same type or different types at the same time.

In a possible implementation, the power adapter further includes at least one power transmission coil. The at least one power transmission coil is connected to the printed circuit board assembly. The at least one power transmission coil is configured to transmit energy to at least one electronic device, to wirelessly charge the at least one electronic device. In this case, the power adapter may wirelessly charge the electronic device.

In a possible implementation, the insulation powder filled in the housing includes the heat storage powder and the thermally conductive powder, which not only can absorb heat generated during continuous working of the power transmission coil and the printed circuit board assembly, but also can quickly dissipate the heat. This improves a heat dissipation capability of the power adapter.

In a possible implementation, the power adapter further includes an input interface and at least one output interface. The input interface is configured to connect to the power supply. The at least one output interface is configured to connect to the electronic device.

In a possible implementation, the printed circuit board assembly is wrapped with a metal sheet to improve heat dissipation efficiency.

Insulation powder is filled in the power adapter of the electronic device system. Compared with a thermally conductive adhesive, the insulation powder does not have a problem of poor fluidity, and can more easily be sufficiently filled. A material with a larger specific heat capacity is selected as heat storage powder, and a heat absorption capability is strong. When an instantaneous heating power of a printed circuit board assembly is high, the heat storage powder may absorb a large amount of heat generated by the printed circuit board assembly. After the instantaneous heating power of the printed circuit board assembly decreases, the heat storage powder gradually releases the stored heat and conducts the heat to a housing. This avoids overheating of the printed circuit board assembly in a short time. A material with a high thermal conductivity is selected as thermally conductive powder. In this case, when a heating power of the printed circuit board assembly is continuously high, the heat generated by the printed circuit board assembly may be continuously and quickly conducted to the housing, thereby alleviating heat accumulation of the printed circuit board assembly.

The electronic device may be a smartphone, a laptop computer, a wearable electronic device (for example, a smartwatch), a tablet computer, an augmented reality (augmented reality, AR) device, a virtual reality (virtual reality, VR) device, a vehicle-mounted device, or the like.

In a possible implementation, the electronic device system further includes a connection cable. A first end of the connection cable is connected to a charging port of the electronic device, and a second end of the connection cable is connected to an output interface of the power adapter. The power adapter charges the electronic device by using a connector.

### BRIEF DESCRIPTION OF DRAWINGS

FIG. 1 is a schematic diagram of a power adapter according to an embodiment of this application;
FIG. 2 is a schematic diagram of another power adapter according to an embodiment of this application;
FIG. 3 is a schematic diagram of still another power adapter according to an embodiment of this application;
FIG. 4 is a schematic diagram of yet another power adapter according to an embodiment of this application;
FIG. 5 is a schematic diagram of still yet another power adapter according to an embodiment of this application;
FIG. 6 is a schematic diagram of a further power adapter according to an embodiment of this application;
FIG. 7 is a schematic diagram of a still further power adapter according to an embodiment of this application;
FIG. 8 is a schematic diagram of a yet further power adapter according to an embodiment of this application;
FIG. 9 is a top view of a still yet further power adapter according to an embodiment of this application;
FIG. 10 is a top view of even yet another power adapter according to an embodiment of this application; and
FIG. 11 is a schematic diagram of an electronic device system according to an embodiment of this application.

### DESCRIPTION OF EMBODIMENTS

To enable a person skilled in the art to better understand technical solutions provided in embodiments of this application, the following first describes an application scenario of a power adapter.

With rapid development and evolution of electronic devices, a charging speed of the electronic devices has gradually attracted more attention. Therefore, fast charging technologies have been gradually applied to various electronic devices. For example, many current smartphones support the fast charging technologies. However, application of the fast charging technologies also brings some problems. An obvious problem is that overheating of the power adapter causes a rapid temperature rise and a high temperature of an enclosure. This may result in a hot-to-touch situation, reducing user experience and even causing a fire hazard in a severe case. Therefore, more efficient heat dissipation is required for the power adapter.

Currently, a heat dissipation manner of the power adapter is filling a thermally conductive adhesive in the power adapter, to transfer heat generated by an electronic component to a housing by using the thermally conductive adhesive, thereby accelerating heat dissipation.

A thermal conductivity of the thermally conductive adhesive is usually between 0.2 watt/(m*degree) (W/(m*K)) and 2.5 W/(m*K) (including 0.2 and 2.5), where K may be replaced by °C. However, an increase in the thermal conductivity of the thermally conductive adhesive causes poor fluidity of the thermally conductive adhesive.

When a thermally conductive adhesive with a low thermal conductivity, for example 0.2 W/(m*K), is used, although internal encapsulation may be implemented and a heat dissipation area is increased, heat dissipation effect is poor due to the low thermal conductivity and heat dissipation is not performed in a timely manner. As a result, a local hot spot is easily formed in the power adapter and on the housing. When a thermally conductive adhesive with a high thermal conductivity, for example 2 W/(m*K), is used, encapsulation cannot be implemented due to poor fluidity, and only the internal electronic component can be dispensed with the adhesive. This reduces a heat dissipation area, and a local hot spot is also easily formed in the power adapter and on the housing.

Therefore, the foregoing heat dissipation manner has poor heat dissipation effect, and limits a further increase in a charging power of the power adapter.

To resolve the foregoing problem, this application provides a power adapter and an electronic device system, and insulation powder is filled in a housing of the power adapter. The insulation powder is a solid. Compared with a thermally conductive adhesive, the insulation powder does not have a problem of poor fluidity, and can more easily be sufficiently filled. This improves heat dissipation effect of the power adapter and helps further increase the charging power of the power adapter.

In this application, a "connection" may be a fixed connection, a detachable connection, or an integrated structure, may be a direct connection, or may be an indirect connection through an intermediary.

The electronic device may be a smartphone, a laptop computer, a wearable electronic device (for example, a smartwatch), a tablet computer, an augmented reality device, a virtual reality device, a vehicle-mounted device, or the like.

An embodiment of this application provides a power adapter. The following provides specific descriptions with reference to the accompanying drawings.

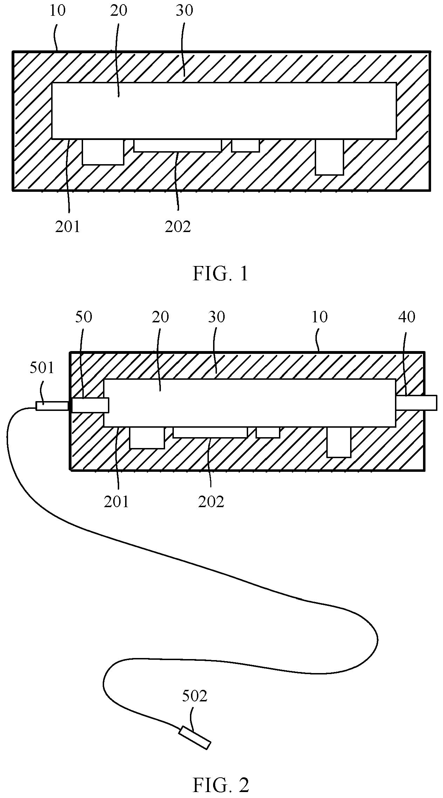

FIG. 1 is a schematic diagram of a power adapter according to an embodiment of this application.

As shown in the figure, the power adapter includes a housing 10, a printed circuit board assembly (Printed Circuit Board Assembly, PCBA) 20, and insulation powder 30.

The printed circuit board assembly 20 is fastened in the housing 10, and includes a printed circuit board (Printed Circuit Board, PCB) 201 and an electronic component 202 disposed on the printed circuit board 201. An implementation of the printed circuit board assembly 20 shown in the figure is only for ease of description.

A specific shape of the housing 10 is not limited in this embodiment of this application. For example, a cube, a cuboid, a cylinder, or another shape may be used. In addition, the housing 10 may be a hard enclosure, or may be a flexible enclosure that has a deformation capability.

The insulation powder 30 (slashes in the figure) is filled in the housing 10, and the insulation powder is a solid. In this embodiment of this application, the insulation powder is used for filling. Compared with a cooling solution in the conventional technology in which a thermally conductive adhesive is filled for encapsulation, the insulation powder can more easily be sufficiently filled. In other words, a contact area between the insulation powder and the printed circuit board assembly is ensured, and heat can be efficiently transferred from the printed circuit board assembly to the insulation powder. This improves heat dissipation effect of the power adapter, and helps further increase a charging power of the power adapter.

The following provides a description with reference to a specific implementation of the insulation powder.

The insulation powder 30 includes at least heat storage powder and thermally conductive powder. A specific heat capacity of the heat storage powder is greater than a specific heat capacity of the thermally conductive powder, and a thermal conductivity of the thermally conductive powder is greater than a thermal conductivity of the heat storage powder.

The heat storage powder is used to store heat generated by the printed circuit board assembly 20, gradually release the stored heat, and conduct the heat to the housing 10. A material with a larger specific heat capacity is selected as the heat storage powder. When a power of the power adapter is high in a short time, the corresponding printed circuit board assembly 20 has a high heating power in a short time. In this case, the heat storage powder may absorb a large amount of heat generated by the printed circuit board assembly. This avoids overheating of the printed circuit board assembly in a short time. After an instantaneous heating power of the printed circuit board assembly decreases, the heat storage powder gradually releases the stored heat and conducts the heat to the housing. It may be understood that, when the heat storage powder absorbs the heat generated by the printed circuit board assembly, the heat is also gradually released to the housing.

A type of used heat storage powder is not specifically limited in this embodiment of this application. For example, a silicate or the like may be used.

The thermally conductive powder is used to quickly conduct the heat generated by the printed circuit board assembly 20 to the housing 10. A material with a high thermal conductivity is selected as the thermally conductive powder. When the power adapter continuously charges an electronic device at a high power, the heating power of the printed circuit board assembly 20 is continuously high. In this case, the thermally conductive powder may quickly conduct the heat generated by the printed circuit board assembly to the housing 10, thereby avoiding continuous accumulation caused by untimely heat dissipation of the printed circuit board assembly.

A type of used thermally conductive powder is not specifically limited in this embodiment of this application. For example, aluminum nitride, aluminum oxide, or the like may be used.

An application scenario of the power adapter is not specifically limited in this embodiment of this application. For example, when the electronic device is a smartphone, a laptop computer, a wearable device, or the like, a power supply connected to the power adapter is usually a mains supply. In other words, an alternating current power supply is connected. When the electronic device is a vehicle-mounted device or the power adapter is specifically a vehicle-mounted charger, the power adapter is connected to a low-voltage battery (also referred to as a storage battery) of a power vehicle. In this case, the power supply connected to the power adapter is a direct current power supply.

The following provides descriptions with reference to a specific implementation of a power adapter.

FIG. 2 is a schematic diagram of another power adapter according to an embodiment of this application.

The power adapter further includes an input pin 40 and at least one output interface 50.

The input pin 40 is configured to connect to a power supply. The input pin 40 is made of a metal material. Positions, a quantity, and a current status of input pins of the power adapter are not specifically limited in this embodiment of this application. Usually, the input pin 40 specifically includes two pins or three pins.

A first end of the input pin 40 is connected to a printed circuit board assembly 20 in a housing 10, and a second end of the input pin is extended outside the housing 10. The second end of the input pin is connected to the power supply.

The output interface 50 is configured to connect to an electronic device. Specifically, in a possible implementation, the output interface is connected to the electronic device by using a cable. A first end of the cable includes a first connector 501 corresponding to the output interface 50, and a second end of the cable includes a second connector 502 corresponding to an input interface of the electronic device.

A type of the output interface 50 of the power adapter is not limited in this embodiment of this application. The output interface may be a Micro USB interface, a Lighting interface, a USB interface, or the like. When the output interface is a USB interface, the output interface may be specifically a USB interface of Type-A, Type-B, or Type-c. A specific quantity of output interfaces is not limited in this embodiment of this application. When the power adapter includes a plurality of output interfaces, the plurality of output interfaces may be a same type or a combination of a plurality of types. In this case, the power adapter supports simultaneous charging on a plurality of electronic devices of a same type or different types.

Electronic components on the printed circuit board assembly 20 mainly include a controller, a capacitor, a magnetic device, a power conversion circuit, and the like. Main heating devices include a switch device of the power conversion circuit, and the magnetic device.

The power switch device may be an insulated gate bipolar transistor (Insulated Gate Bipolar Transistor, IGBT), a metal-oxide-semiconductor field-effect transistor (Metal-Oxide-Semiconductor Field-Effect Transistor, MOSFET), a silicon carbide metal-oxide-semiconductor field-effect transistor (Silicon Carbide Metal-Oxide-Semiconductor Field-Effect Transistor, SiC MOSFET), or the like. This is not specifically limited in this embodiment of this application.

The magnetic device may be a transformer, an inductor, or the like.

In some embodiments, the printed circuit board assembly may be further wrapped with a metal sheet to assist heat dissipation.

In the foregoing descriptions, an example in which insulation powder is directly filled in a housing is used. The following describes another filling manner of the insulation powder.

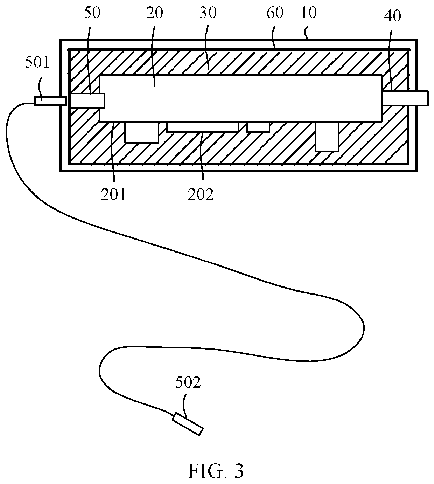

FIG. 3 is a schematic diagram of still another power adapter according to an embodiment of this application.

A difference between the power adapter shown in this figure and that shown in FIG. 2 is that an inner housing 60 is further disposed in the housing 10 and the printed circuit board assembly 20 is fastened in the inner housing 60.

An enclosed cavity is formed between the housing 10 and the inner housing 60. The insulation powder is filled in the inner housing 60.

After the enclosed cavity is formed, a layer of protection of the inner housing 60 is added, to avoid direct leakage of the insulation powder due to damage and breakage of the housing 10. In addition, when heat of the inner housing is transferred to the housing, the heat is further dissipated, thereby improving uniformity of heat distribution. Therefore, the enclosed cavity further avoids that the heat is directly transferred to the housing 10 to form a local over-hot spot, which causes poor user experience when the user touches the housing.

In some embodiments, air is filled in the enclosed cavity. In some other embodiments, to enhance a heat transfer speed and a heat dissipation degree when the heat is transferred from the inner housing to the housing, a thermally conductive adhesive or a coolant may be filled in the enclosed cavity, and the inner housing 60 may also be made of the metal material.

The following describes another filling manner of the insulation powder.

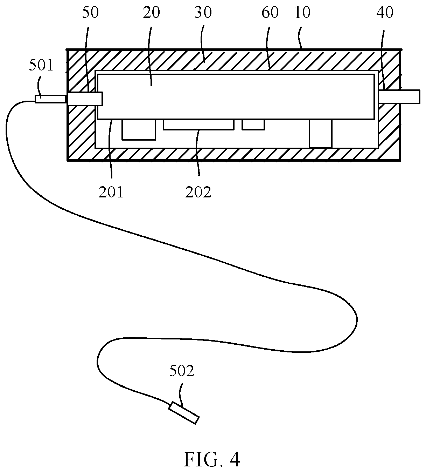

FIG. 4 is a schematic diagram of yet another power adapter according to an embodiment of this application.

A difference between the power adapter shown in this figure and that shown in FIG. 2 is that an inner housing 60 is further disposed in the housing 10 and the printed circuit board assembly 20 is fastened in the inner housing 60.

An enclosed cavity is formed between the housing 10 and the inner housing 60. The insulation powder is filled in the enclosed cavity.

The inner housing 60 is in direct contact with the printed circuit board assembly 20, and a gap shown in the figure is only used to distinguish between a contact surface of the inner housing 60 and the printed circuit board assembly 20.

One side of the inner housing 60 is in direct contact with the printed circuit board assembly 20, and the other side of the inner housing 60 is in direct contact with the insulation powder. Therefore, the inner housing 60 may quickly transfer heat generated by the printed circuit board assembly 20 to the insulation powder.

In some embodiments, to improve a speed at which the inner housing 60 transfers the heat generated by the printed circuit board assembly 20 to the insulation powder, the inner housing is provided with a slot. The following provides detailed descriptions with reference to the accompanying drawings.

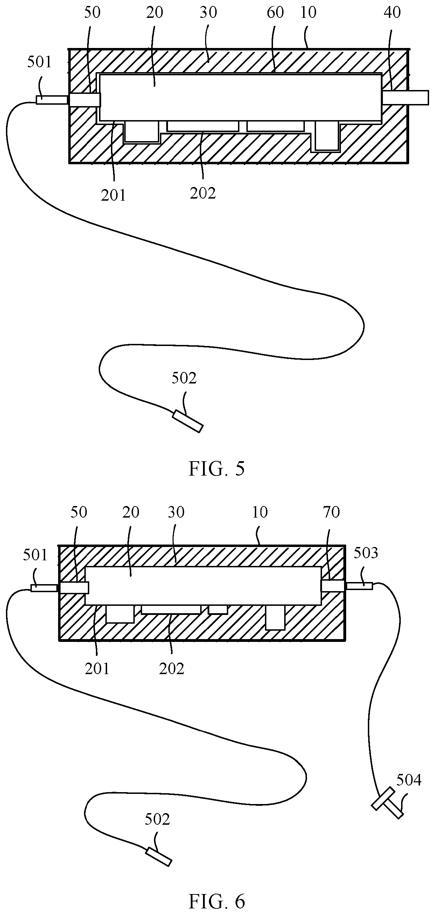

FIG. 5 is a schematic diagram of still yet another power adapter according to an embodiment of this application.

An inner housing 60 of the power adapter shown in the figure is provided with a slot, and the slot is configured to accommodate an electronic component 202 on the printed circuit board assembly 20.

Compared with the implementation shown in FIG. 2, this implementation increases a contact area between the inner housing 60 and the electronic component 202, and increases a speed at which the inner housing 60 transfers the heat generated by the printed circuit board assembly 20 to the insulation powder. In addition, the slot further has a function of supporting the electronic component 202. This enhances stability of the electronic component 202, and therefore further improves reliability of the power adapter.

A type and a proportion of the insulation powder filled in the power adapter may be determined based on a function of the power adapter. Details are described below.

The proportion in the following description is a mass ratio or a volume ratio.

In some embodiments, the power adapter is configured to charge a small electronic device such as a smartphone or a smartwatch, and the power adapter supports fast charging, and can charge a battery of the electronic device with sufficient power in a short charging time. However, with continuous development of fast charging technologies, to continuously reduce a charging time, a charging power of the power adapter has gradually increased. For example, some smartphones need only 10 minutes to have their batteries charged to 50% or even higher of a maximum battery level. In this case, when the power adapter is configured to perform charging on the electronic device, an instantaneous heating power of the printed circuit board assembly is high due to the high charging power in a short time. To avoid a rapid temperature rise of the printed circuit board assembly in a short time, a proportion of filled heat storage powder is greater than a proportion of filled thermally conductive powder, or only the heat storage powder is filled. Because the heat storage powder has a larger specific heat capacity, a large amount of heat generated by the printed circuit board assembly may be absorbed.

It may be understood that, when the heat storage powder absorbs the heat generated by the printed circuit board assembly, the heat is also conducted gradually to the housing 10 in FIG. 2, FIG. 4, and FIG. 5 or to the inner housing 60 in FIG. 3 to cool down gradually.

After the power adapter finishes fast charging or the instantaneous heating power decreases, the heat storage powder continues to transfer remaining unreleased heat gradually to the housing 10 in FIG. 2, FIG. 4, and FIG. 5 or to the inner housing 60 in FIG. 3.

In some other embodiments, the power adapter is configured to charge an electronic device with a high battery capacity, such as a laptop computer. In this case, in addition to the foregoing implementations, the power adapter may further use an implementation shown in FIG. 6.

In this case, an input pin of the power adapter is replaced with an input interface 70. The input interface 70 is connected to a power supply by using a cable. A first end of the cable includes a third connector 503 corresponding to the input interface 70, and a second end of the cable includes a fourth connector 504 connected to the power supply. Types of the input interface 70, the third connector 503, and the fourth connector 504 are not specifically limited in this embodiment of this application.

In this case, an output interface 50 and a first connector 501 may be designed to be detachable, or may be set to be non-detachable. The input interface 70 and the third connector 503 may be designed to be detachable, or may be set to be non-detachable. This is not specifically limited in this embodiment of this application.

In this case, the charging power of the power adapter keeps high throughout a charging process. To continuously and quickly conduct the heat generated by the printed circuit board assembly to the housing and to alleviate heat accumulation of the printed circuit board assembly, a proportion of filled thermally conductive powder is greater than a proportion of filled heat storage powder, to improve a heat conduction capability.

In conclusion, the solution provided in embodiments of this application easily implements filling, and improves heat dissipation effect when a power adapter performs wired charging on an electronic device. This further increases the charging power of the power adapter.

The foregoing describes examples in which a power adapter performs wired charging on an electronic device. The following describes implementations in which a power adapter performs wireless charging on an electronic device.

The power adapter that supports wireless charging includes a vertical type, a horizontal type, and the like. The following first describes an implementation in which wireless charging is implemented by using the power adapter of the vertical type.

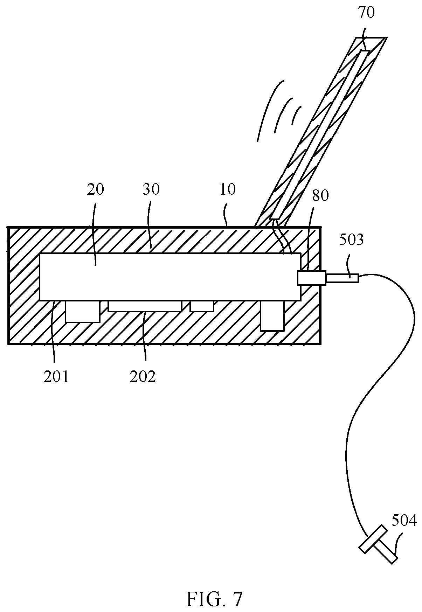

FIG. 7 is a schematic diagram of a still further power adapter according to an embodiment of this application.

The power adapter shown in the figure supports wireless charging, and is usually configured to charge a small electronic device such as a smartphone and a smartwatch. In this case, a power transmission coil 80 is further included in a housing of the power adapter, and the power transmission coil 80 is connected to a printed circuit board assembly 20.

The power transmission coil 80 generates an alternating magnetic field by using an alternating current, and transmits energy to the electronic device, to wirelessly charge the electronic device.

Currently, a charging time of wireless charging on the electronic device is usually longer than that of wired fast charging, and the power transmission coil 80 also generates heat. In this case, to efficiently dissipate heat for the power transmission coil 80 and the printed circuit board assembly 20 within a relatively long charging time, both heat storage powder and thermally conductive powder are filled in the housing of the power adapter to absorb heat generated during continuous working of the power transmission coil 80 and the printed circuit board assembly 20 and quickly dissipate the heat. This improves a heat dissipation capability of the power adapter.

The following describes an implementation in which wireless charging is implemented by using the power adapter of the horizontal type.

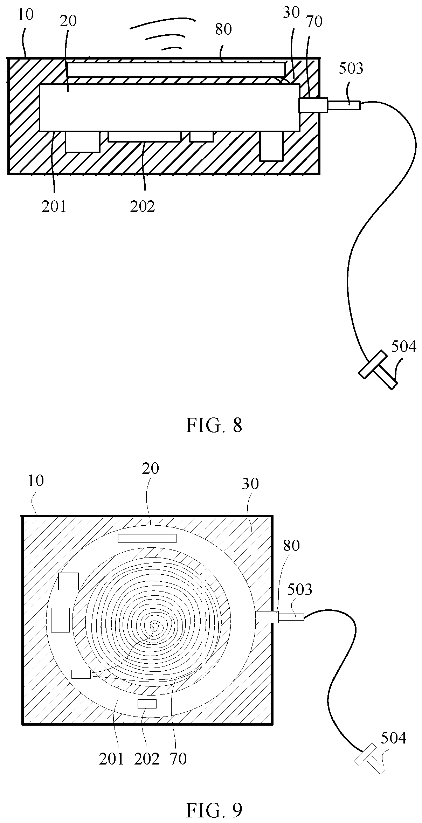

Refer to FIG. 8 and FIG. 9. FIG. 8 is a schematic diagram of a yet further power adapter according to an embodiment of this application. FIG. 9 is a schematic diagram of a still yet further power adapter according to an embodiment of this application.

The power transmission coil 80 in the power adapter of the horizontal type is horizontally disposed. In some embodiments, as shown in FIG. 8, the power transmission coil 80 is fastened above the printed circuit board assembly 20. In some other embodiments, as shown in FIG. 9, the printed circuit board assembly 20 is in a shape of an annular strip, and the power transmission coil 80 is fastened on an inner side of the printed circuit board assembly 20. This may reduce a height of the power adapter and improve portability.

The power transmission coil 80 is connected to the printed circuit board assembly 20, and is configured to generate the alternating magnetic field by using the alternating current, and transmit energy to the electronic device, to wirelessly charge the electronic device. The electronic device accordingly has a power receiving coil. The power receiving coil is configured to generate the alternating current by using the alternating magnetic field, and then convert the alternating current into a direct current by using a rectifier circuit, to charge a battery.

Both the heat storage powder and the thermally conductive powder are filled in the housing of the power adapter to absorb the heat generated during continuous working of the power transmission coil 80 and the printed circuit board assembly 20 and quickly dissipate the heat. This improves a heat dissipation capability of the power adapter.

During actual application, the power adapter may further include a plurality of power transmission coils, to enable the power adapter to wirelessly charge a plurality of electronic devices simultaneously or to charge a same electronic device with different wireless charging powers.

In conclusion, the solution provided in embodiments of this application easily implements filling, and improves heat dissipation effect when a power adapter performs wireless charging on an electronic device. This further increases the charging power of the power adapter.

The foregoing separately describes implementations of wired charging or wireless charging performed by a power adapter. During actual application, the power adapter supports both wired charging and wireless charging. The following provides specific descriptions with reference to the accompanying drawings.

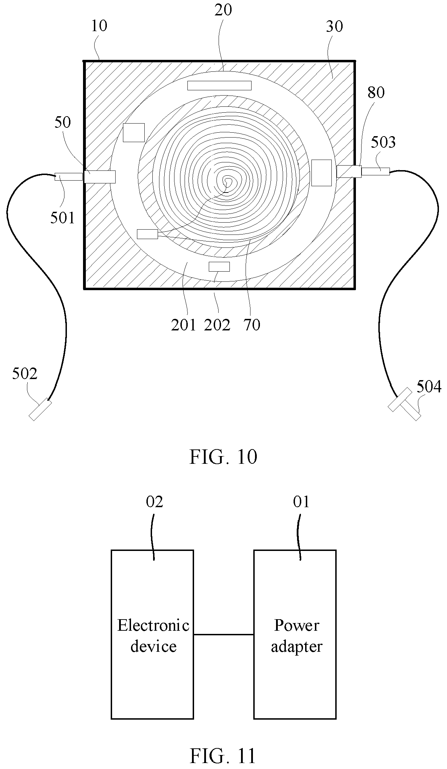

FIG. 10 is a top view of even yet another power adapter according to an embodiment of this application.

A difference between the power adapter shown in FIG. 10 and that shown in FIG. 9 is that the power adapter further includes an output interface 50. The output interface 50 is configured to connect to an electronic device. In a possible implementation, the output interface is connected to the electronic device by using a cable. A first end of the cable includes a first connector 501 corresponding to the output interface 50, and a second end of the cable includes a second connector 502 corresponding to an input interface of the electronic device.

In this case, both heat storage powder and thermally conductive powder are filled in a housing of the power adapter to absorb heat generated during continuous working of a power transmission coil 80 and a printed circuit board assembly 20 and quickly dissipate the heat. This improves a heat dissipation capability of the power adapter.

It may be understood that the foregoing descriptions are provided by using an example in which a wireless charging coil is horizontally disposed. A principle used when the wireless charging coil is vertically disposed is similar. Details are not described again in this embodiment of this application.

In conclusion, according to the solution in embodiments of this application, when the power adapter can perform both wireless charging and wired charging, heat dissipation effect of the power adapter can be improved. This further increases the charging power of the power adapter.

Based on the power adapter provided in the foregoing embodiments, an embodiment of this application further provides an electronic device system. The following provides a specific description with reference to the accompanying drawing.

FIG. 11 is a schematic diagram of an electronic device system according to an embodiment of this application.

The electronic device system shown in the figure includes a power adapter 01 and an electronic device 02.

The power adapter 01 is configured to charge the electronic device. For a specific implementation of the power adapter 01, refer to related descriptions in the foregoing embodiments. Details are not described in this embodiment of this application again.

The electronic device 02 may be a smartphone, a laptop computer, a wearable electronic device (for example, a smartwatch), a tablet computer, an augmented reality device, a virtual reality device, a vehicle-mounted device, or the like. This is not specifically limited in this embodiment of this application.

The power adapter 01 supports a wired charging function, a wireless charging function, or both a wired charging function and a wireless charging function. The power adapter 01 may charge one or more electronic devices 02 at the same time. When the power adapter 01 charges a plurality of electronic devices 02 at the same time, the plurality of electronic devices 02 may be electronic devices of a same type or different types. When the power adapter 01 performs wired charging on the electronic device, the electronic device system further includes a connection cable. A first end of the connection cable is connected to a charging port of the electronic device, and a second end of the connection cable is connected to an output interface of the power adapter.

During actual application, the power adapter 01 may be directly connected to a power supply by using a pin, or may be connected to the power supply by using the connection cable. This is not specifically limited in this embodiment of this application.

According to the solution provided in this application, insulation powder is filled in the power adapter. Compared with a thermally conductive adhesive, the insulation powder does not have a problem of poor fluidity, and can more easily be sufficiently filled. A material with a larger specific heat capacity is selected as heat storage powder, and a heat absorption capability is strong. When an instantaneous heating power of a printed circuit board assembly is high, the heat storage powder may absorb a large amount of heat generated by the printed circuit board assembly. After the instantaneous heating power of the printed circuit board assembly decreases, the heat storage powder gradually releases the stored heat and conducts the heat to the housing. This avoids overheating of the printed circuit board assembly in a short time. A material with a high thermal conductivity is selected as thermally conductive powder. In this case, when a heating power of the printed circuit board assembly is continuously high, the heat generated by the printed circuit board assembly may be continuously and quickly conducted to the housing, thereby alleviating heat accumulation of the printed circuit board assembly.

In conclusion, the solution provided in embodiments of this application easily implements filling, and improves heat dissipation effect of the power adapter. This further increases the charging power of the power adapter.

## Claims

1. A power adapter (01), configured to charge an electronic device (02) by using a power supply, wherein the power adapter (01) comprises a housing (10), a printed circuit board assembly (20), and insulation powder (30) filled in the housing;
the printed circuit board assembly (20) is fastened in the housing (10); and
the insulation powder (30) is used to conduct heat generated by the printed circuit board assembly (20) to the housing (10),
wherein the insulation powder (30) comprises a combination of heat storage powder and the thermally conductive powder;
the heat storage powder is used to store the heat generated by the printed circuit board assembly (20), release the stored heat, and conduct the heat to the housing (10);
the thermally conductive powder is used to conduct the heat generated by the printed circuit board assembly (20) to the housing (10); and
a specific heat capacity of the heat storage powder is greater than a specific heat capacity of the thermally conductive powder, and a thermal conductivity of the thermally conductive powder is greater than a thermal conductivity of the heat storage powder,
wherein a proportion of the thermally conductive powder filled in the housing is greater than a proportion of the filled heat storage powder, and the proportion is a mass ratio or a volume ratio.

2. The power adapter according to claim 1, wherein an inner housing (60) is further disposed in the housing, and the printed circuit board assembly is fastened in the inner housing (60);
an enclosed cavity is formed between the housing and the inner housing (60); and
the insulation powder is filled between the inner housing (60) and the printed circuit board assembly.

3. The power adapter according to claim 2, wherein a thermally conductive adhesive or a coolant is filled in the enclosed cavity.

4. The power adapter according to claim 2 or 3, wherein the inner housing is made of a metal material.

5. The power adapter according to claim 1, wherein an inner housing is further disposed in the housing, and the printed circuit board assembly is fastened in the inner housing;
an enclosed cavity is formed between the housing and the inner housing; and
the insulation powder is filled in the enclosed cavity.

6. The power adapter according to any one of claims 1 to 5, further comprising an input pin (40) and at least one output interface (50), wherein
the input pin (40) is configured to connect to the power supply;
a first end of the input pin (40) is connected to the printed circuit board assembly in the housing, and a second end of the input pin (40) is extended outside the housing; and
the at least one output interface (50) is configured to connect to the electronic device.

7. The power adapter according to any one of claims 1 to 5, further comprising an input interface (70), wherein the input interface (70) is configured to connect to the power supply.

8. The power adapter according to claim 7, further comprising at least one output interface (50), wherein the at least one output interface (50) is configured to connect to the electronic device.

9. The power adapter according to claim 7 or 8, further comprising at least one power transmission coil (80), wherein the at least one power transmission coil (80) is connected to the printed circuit board assembly; and
the at least one power transmission coil (80) is configured to transmit energy to at least one electronic device, to wirelessly charge the at least one electronic device.

10. The power adapter according to any one of claims 1 to 9, wherein the printed circuit board assembly is wrapped with a metal sheet.

11. An electronic device system, wherein the electronic device system comprises the power adapter (01) according to any one of claims 1 to 10, and further comprises an electronic device (02); and
the power adapter (01) is configured to charge the electronic device (02).

12. The electronic device system according to claim 11, wherein the electronic device system further comprises a connection cable; and
a first end of the connection cable is connected to a charging port of the electronic device, and a second end of the connection cable is connected to an output interface of the power adapter.

## Patentansprüche

1. Netzteil (01), das dafür ausgelegt ist, eine elektronische Vorrichtung (02) durch Verwendung einer Stromversorgung aufzuladen, wobei das Netzteil (01) ein Gehäuse (10), eine Leiterplattenbaugruppe (20) und in das Gehäuse gefülltes Isolationspulver (30) umfasst;
die Leiterplattenbaugruppe (20) in dem Gehäuse (10) befestigt ist; und
das Isolationspulver (30) verwendet wird, um durch die Leiterplattenbaugruppe (20) erzeugte Wärme auf das Gehäuse (10) zu leiten,
wobei das Isolationspulver (30) eine Kombination von Wärmespeicherpulver und wärmeleitendem Pulver umfasst;
das Wärmespeicherpulver verwendet wird, um die durch die Leiterplattenbaugruppe (20) erzeugte Wärme zu speichern, die gespeicherte Wärme abzugeben und die Wärme auf das Gehäuse (10) zu leiten;
das wärmeleitende Pulver verwendet wird, um die durch die Leiterplattenbaugruppe (20) erzeugte Wärme auf das Gehäuse (10) zu leiten; und
eine spezifische Wärmekapazität des Wärmespeicherpulvers größer als eine spezifische Wärmekapazität des wärmeleitenden Pulvers ist und eine Wärmeleitfähigkeit des wärmeleitenden Pulvers größer als eine Wärmeleitfähigkeit des Wärmespeicherpulvers ist,
wobei ein Anteil des in das Gehäuse gefüllten wärmeleitenden Pulvers größer als ein Anteil des in das Gehäuse gefüllten Wärmespeicherpulvers ist und der Anteil ein Massenverhältnis oder ein Volumenverhältnis ist.

2. Netzteil nach Anspruch 1, wobei ferner ein inneres Gehäuse (60) in dem Gehäuse angeordnet ist und die Leiterplattenbaugruppe in dem inneren Gehäuse (60) befestigt ist;
zwischen dem Gehäuse und dem inneren Gehäuse (60) ein geschlossener Hohlraum gebildet wird; und
das Isolationspulver zwischen das innere Gehäuse (60) und die Leiterplattenbaugruppe gefüllt wird.

3. Netzteil nach Anspruch 2, wobei ein wärmeleitender Kleber oder ein Kühlmittel in den geschlossenen Hohlraum gefüllt wird.

4. Netzteil nach Anspruch 2 oder 3, wobei das innere Gehäuse aus einem Metallmaterial besteht.

5. Netzteil nach Anspruch 1, wobei ferner ein inneres Gehäuse in dem Gehäuse angeordnet ist und die Leiterplattenbaugruppe in dem inneren Gehäuse befestigt ist; zwischen dem Gehäuse und dem inneren Gehäuse ein geschlossener Hohlraum gebildet wird; und
das Isolationspulver in den geschlossenen Hohlraum gefüllt wird.

6. Netzteil nach einem der Ansprüche 1 bis 5, das ferner einen Eingangsanschluss (40) und mindestens eine Ausgangsschnittstelle (50) umfasst, wobei
der Eingangsanschluss (40) ausgelegt ist zur Verbindung mit der Stromversorgung;
ein erstes Ende des Eingangsanschlusses (40) mit der Leiterplattenbaugruppe in dem Gehäuse verbunden ist und ein zweites Ende des Eingangsanschlusses (40) außerhalb des Gehäuses verlängert ist; und
die mindestens eine Ausgangsschnittstelle (50) ausgelegt ist zur Verbindung mit der elektronischen Vorrichtung.

7. Netzteil nach einem der Ansprüche 1 bis 5, das ferner eine Eingangsschnittstelle (70) umfasst, wobei die Eingangsschnittstelle (70) ausgelegt ist zur Verbindung mit der Stromversorgung.

8. Netzteil nach Anspruch 7, das ferner mindestens eine Ausgangsschnittstelle (50) umfasst, wobei die mindestens eine Ausgangsschnittstelle (50) ausgelegt ist zur Verbindung mit der elektronischen Vorrichtung.

9. Netzteil nach Anspruch 7 oder 8, das ferner mindestens eine Energieübertragungsspule (80) umfasst, wobei die mindestens eine Energieübertragungsspule (80) mit der Leiterplattenbaugruppe verbunden ist; und
die mindestens eine Energieübertragungsspule (80) ausgelegt ist zum Übertragen von Energie zu mindestens einer elektronischen Vorrichtung, um die mindestens eine elektronische Vorrichtung drahtlos aufzuladen.

10. Netzteil nach einem der Ansprüche 1 bis 9, wobei die Leiterplattenbaugruppe mit einer Metallfolie eingewickelt ist.

11. Elektronisches Vorrichtungssystem, wobei das elektronische Vorrichtungssystem das Netzteil (01) nach einem der Ansprüche 1 bis 10 umfasst und ferner eine elektronische Vorrichtung (02) umfasst; und
das Netzteil (01) ausgelegt ist zum Aufladen der elektronischen Vorrichtung (02).

12. Elektronisches Vorrichtungssystem nach Anspruch 11, wobei das elektronische Vorrichtungssystem ferner ein Verbindungskabel umfasst; und
ein erstes Ende des Verbindungskabels mit einem Ladeanschluss der elektronischen Vorrichtung verbunden ist und ein zweites Ende des Verbindungskabels mit einer Ausgangsschnittstelle des Netzteils verbunden ist.

## Revendications

1. Adaptateur d'alimentation (01) configuré pour charger un dispositif électronique (02) à l'aide d'une alimentation électrique, dans lequel l'adaptateur d'alimentation (01) comprend un boîtier (10), un ensemble de carte de circuit imprimé (20) et une poudre isolante (30) remplissant le boîtier ;
l'ensemble de carte de circuit imprimé (20) est fixé dans le boîtier (10) ; et
la poudre isolante (30) est utilisée pour conduire la chaleur générée par l'ensemble de carte de circuit imprimé (20) vers le boîtier (10),
où la poudre isolante (30) comprend une combinaison de poudre accumulatrice de chaleur et de poudre thermoconductrice ;
la poudre accumulatrice de chaleur est utilisée pour accumuler la chaleur générée par l'ensemble de carte de circuit imprimé (20), libérer la chaleur accumulée et conduire la chaleur vers le boîtier (10) ;
la poudre thermoconductrice est utilisée pour conduire la chaleur générée par l'ensemble de carte de circuit imprimé (20) vers le boîtier (10) ; et
une capacité thermique spécifique de la poudre accumulatrice de chaleur est supérieure à une capacité thermique spécifique de la poudre thermoconductrice, et une conductivité thermique de la poudre thermoconductrice est supérieure à une conductivité thermique de la poudre accumulatrice de chaleur,
où une proportion de la poudre thermoconductrice remplissant le boîtier est supérieure à une proportion de la poudre accumulatrice de chaleur le remplissant, et la proportion est un rapport massique ou un rapport volumique.

2. Adaptateur d'alimentation selon la revendication 1, dans lequel un boîtier interne (60) est en outre disposé dans le boîtier, et l'ensemble de carte de circuit imprimé est fixé dans le boîtier interne (60) ;
une cavité fermée est formée entre le boîtier et le boîtier interne (60) ; et
la poudre isolante est remplie entre le boîtier interne (60) et l'ensemble de carte de circuit imprimé.

3. Adaptateur d'alimentation selon la revendication 2, dans lequel un adhésif thermoconducteur ou un liquide de refroidissement est rempli dans la cavité fermée.

4. Adaptateur d'alimentation selon la revendication 2 ou 3, dans lequel le boîtier interne est fabriqué à partir d'un matériau métallique.

5. Adaptateur d'alimentation selon la revendication 1, dans lequel un boîtier interne est en outre disposé dans le boîtier, et l'ensemble de carte de circuit imprimé est fixé dans le boîtier interne ;
une cavité fermée est formée entre le boîtier et le boîtier interne ; et
la poudre isolante est remplie dans la cavité fermée.

6. Adaptateur d'alimentation selon l'une quelconque des revendications 1 à 5, comprenant en outre une broche d'entrée (40) et au moins une interface de sortie (50), où
la broche d'entrée (40) est configurée pour se connecter à l'alimentation électrique ; une première extrémité de la broche d'entrée (40) est connectée à l'ensemble de carte de circuit imprimé dans le boîtier, et une deuxième extrémité de la broche d'entrée (40) est prolongée à l'extérieur du boîtier ; et
l'au moins une interface de sortie (50) est configurée pour se connecter au dispositif électronique.

7. Adaptateur d'alimentation selon l'une quelconque des revendications 1 à 5, comprenant en outre une interface d'entrée (70), où l'interface d'entrée (70) est configurée pour se connecter à l'alimentation électrique.

8. Adaptateur d'alimentation selon la revendication 7, comprenant en outre au moins une interface de sortie (50), où l'au moins une interface de sortie (50) est configurée pour se connecter au dispositif électronique.

9. Adaptateur d'alimentation selon la revendication 7 ou 8, comprenant en outre au moins une bobine de transmission d'énergie (80), où l'au moins une bobine de transmission d'énergie (80) est connectée à l'ensemble de carte de circuit imprimé ; et
l'au moins une bobine de transmission d'énergie (80) est configurée pour transmettre de l'énergie à au moins un dispositif électronique, afin de charger sans fil l'au moins un dispositif électronique.

10. Adaptateur d'alimentation selon l'une quelconque des revendications 1 à 9, dans lequel l'ensemble de carte de circuit imprimé est enveloppé d'une feuille métallique.

11. Système de dispositif électronique, le système de dispositif électronique comprenant l'adaptateur d'alimentation (01) selon l'une quelconque des revendications 1 à 10, et comprenant en outre un dispositif électronique (02) ; et
l'adaptateur d'alimentation (01) étant configuré pour charger le dispositif électronique (02).

12. Système de dispositif électronique selon la revendication 11, le système de dispositif électronique comprenant en outre un câble de connexion ; et
une première extrémité du câble de connexion étant connectée à un port de charge du dispositif électronique, et une deuxième extrémité du câble de connexion étant connectée à une interface de sortie de l'adaptateur d'alimentation.
